# EUROPÄISCHE PATENTSCHRIFT

(11) **EP 0 456 150 B1**
(45) Veröffentlichungstag und Bekanntmachung des Hinweises auf die Patenterteilung: **07.09.1994**
(21) Anmeldenummer: 91107305.4
(22) Anmeldetag: 06.05.1991
(51) Int. Cl.: C04B 35/00, C01G 3/00, H01L 39/24

(54) **Lösung und ihre Verwendung zur Herstellung supraleitender Fäden und Beschichtungen**
Solution and its use for the production of superconducting fibers and coatings
Solution et son utilisation pour fabriquer des fils supraconducteurs et revêtements

(30) Priorität: 07.05.1990 DE 4014570
(43) Veröffentlichungstag der Anmeldung: 13.11.1991
(73) Patentinhaber: HOECHST AKTIENGESELLSCHAFT, 65926 Frankfurt am Main (DE)
(72) Erfinder: Becker, Winfried, Dr., W-6233 Kelkheim/Taunus (DE)

(56) Entgegenhaltungen:
- EP-A- 0 341 030
- EP-A- 0 360 550
- WORLD PATENT INDEX LATEST, Woche 13, Accession Nr. 89-096327, Derwent Publications Ltd, London, GB; & JP-A-1 043 910 (TORAY IND. INC.) 16-02-1989
- WORLD PATENT INDEX LATEST, Woche 10, Accession Nr. 89-072181, Derwent Publications Ltd, London, GB; & JP-A-1 024 017 (NIPPON TELEG. & TELEPH.)

## Beschreibung

Die Erfindung betrifft eine hochviskose Lösung, die die Kationen der Metalle Kupfer und Yttrium, Barium oder Bi + Sr + Ca in bestimmten Mengenverhältnissen enthält, ein Verfahren zur Herstellung der Lösung und die Verwendung der Lösung zur Herstellung eines supraleitenden Fadens oder einer supraleitenden Beschichtung auf einem thermisch beständigen Substrat.

Seit der Entdeckung der supraleitenden Eigenschaften des Lantanbariumcuprats durch Bednorz und Müller sind eine Vielzahl weiterer supraleitender Oxid-Keramiken aufgefunden worden. Diese Verbindungen besitzen hohe kritische Temperaturen (T_{c}), die zum Teil oberhalb der Siedetemperatur von Stickstoff liegen. Da dieses Kühlmittel wesentlich billiger als Helium ist, verringern sich die Betriebskosten supraleitender Geräte und Anlagen erheblich. Geeignete supraleitende Oxidkeramiken die neue, umfassende Anwendungsmöglichkeiten eröffnen, sind daher von großem technischen Interesse.

Allen neuen Supraleitern sind nicht-duktile Oxid-Keramiken, mit dem Nachteil, daß sie nur schwer zu den für technische Anwendungen notwendigen Fasern, Fäden, Bändern oder Schichten zu verarbeiten sind. Es bestand daher die Aufgabe, ein Verfahren zu entwickeln, mit dem es gelingt oxidische Supraleiter in Form von Fäden oder Beschichtungen herzustellen.

Der Erfindung liegt die Erkenntnis zugrunde, daß aus wasserlöslichen Metallsalzen und niedermolekularer Polyacrylsäure viskose Lösungen hergestellt werden können, die in Kontakt mit geeigneten organischen Fällbädern gut zu kompakten Fäden, Bändern oder Schichten verarbeitet werden können, die unter Beibehaltung der Form in Supraleiter überführt werden können.

Die rheologischen Eigenschaften dieser viskosen Lösungen sind über das Molekulargewicht der Polyacrylsäure, die Konzentration an Metallpolyacrylat, den Überschuß an Polyacrylsäure und den pH-Wert der Lösung in weiten Grenzen variierbar und daher für verschiedene Anwendungen optimierbar.

Die erfindungsgemäßen viskosen Lösungen enthalten die Kationen der Metalle Y, Ba, Cu bzw. der Metalle Bi, Sr, Ca und Cu in Atomverhältnissen, die denen eines Hochtemperatur-Supraleiters entsprechen, gebunden an Polyacrylsäure mit Wasser als Dispergiermittel. Im Falle des Y-Ba-Cu-Supraleiters beträgt das Atomverhältnis Y:Ba:Cu = 1:2:3 Hochtemperatur-Supraleiter, die die Metalle Bi, Ca, Sr und Cu enthalten, sind mit ihrer Zusammensetzung dem Fachmann bekannt, z.B. aus H.G. Schnering et al., Angew. Chemie, 100 (1988) 604.

Erfindungsgemäße Lösungen, die Y, Ba und Cu enthalten, lassen sich dadurch herstellen, daß man wasserlösliche Salze der Metalle Y, Ba und Cu in Wasser oder als säurelösliche Salze in Säure im Atomverhältnis 1:2:3 löst, die Lösung mit einer wäßrigen Lösung von Polyacrylsäure versetzt, so daß pro Carboxylgruppe der Polyacrylsäure 0,03 bis 0,15 Atome Y³⁺ vorhanden sind und man durch Zugabe einer thermisch abbaubaren Base einen pH-Wert von 10 bis 11 einstellt. Bevorzugt ist das Arbeiten mit wäßrigen Säuren

Vorzugsweise weist die eingesetzte Polyacrylsäure ein mittleres Molekulargewicht im Bereich von 1000 bis 10000, insbesondere 2000 bis 5000 auf. Man kann dieser Polyacrylsäure noch bis zu 50 Gew.-% einer Polyacrylsäure mit höherem Molekulargewicht, insbesondere von 5 x 10⁵ bis 1 x 10⁶ zusetzen und erreicht so - bei gleicher Menge an Acrylat-Einheiten in der Lösung - einen deutlichen Anstieg der Viskosität.

Als thermisch abbaubare Base läßt sich beispielsweise Ammoniak oder Tetramethylammoniumhydroxid einsetzen. Die Verwendung von nicht thermisch abbaubaren Basen, wie z.B. Natriumhydroxid, führt zu einer unerwünschten Verunreinigung der Supraleiter durch fremde Kationen. Bei einem pH-Wert von mindestens 10, insbesondere von 10 bis 11, weist die Metallacrylat-Lösung eine zum Verspinnen ausreichende Viskosität auf. PH-Werte über 11 weisen keine Vorteile auf.

Es ist zweckmäßig, die Ansätze so weit einzudicken, bis sie eine Viskosität von 150 bis 10 000 cSt aufweisen. Lösungen mit noch höherer Viskosität lassen sich nur schwer verarbeiten. Im Prinzip ist jedoch - bei gleicher Viskosität - eine möglichst hohe Konzentration an Kationen wünschenswert. Im allgemeinen weisen verarbeitbare Gele/Lösungen Konzentrationen von 200 bis 400 g/L Polyacrylat auf (gerechnet als freie Polyacrylsäure).

Erfindungsgemäße Lösungen, die die Kationen der Metalle Bi, Sr, Ca und Cu enthalten, lassen sich dadurch herstellen, daß man in Wasser wasserlösliche oder in Säure säurelösliche Salze dieser Metalle mit einem Atomverhältnis, das einem Hochtemperatur-Supraleiter entspricht, löst, man die Lösung mit einer wäßrigen Lösung von Polyacrylsäure vereinigt, wobei pro Carboxylgruppe der Polyacrylsäure 0,04 bis 0,4 Atome Cu²⁺ vorhanden sind und man durch Zugabe einer thermisch abbaubaren Base einen pH-Wert von mindestens 10 einstellt. Für die eingesetzte Polyacrylsäure gilt das oben Gesagte.

Die Nitrate von Y, Ba, Sr und Cu sind leicht wasserlöslich. Die Nitrate von Bi lösen sich in Säure. Mit ihrer Hilfe können daher gut hohe Metall-Konzentrationen in der viskosen Lösung erhalten werden.

Zur Herstellung eines supraleitenden Fadens wird eine beschriebene viskose Lösung durch eine Düse gepreßt und der ausgepreßte fadenförmige Strang in einem mit Wasser mischbaren organischen Lösungsmittel erstarren gelassen. Der blaue Faden wird isoliert, eventuell in Stücke geschnitten, getrocknet, in Abhängigkeit von der Art des zu bildenden Supraleiters auf eine Temperatur von mindestens 800°C in Gegenwart von Sauerstoff erhitzt und bei mindestens 800°C für mindestens eine Stunde in Gegenwart von Sauerstoff getempert und dann abgekühlt.

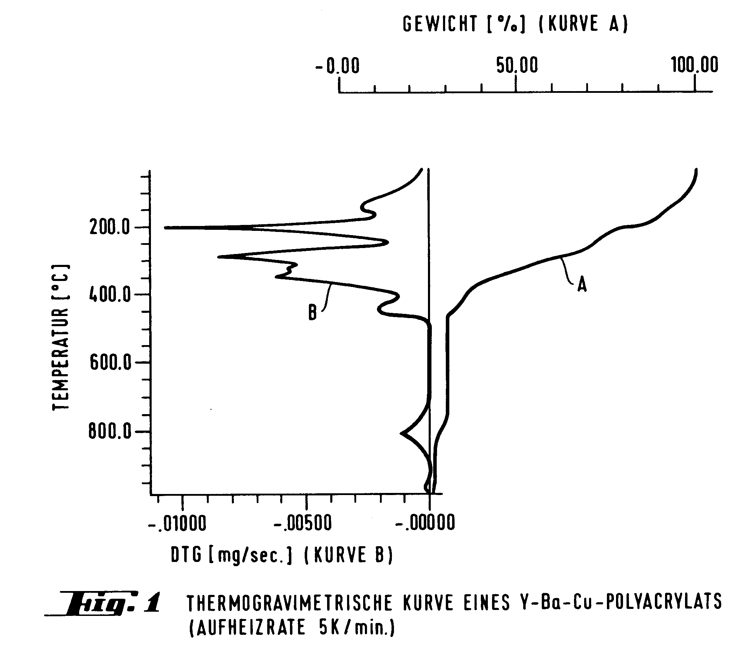

Die Düse ist üblicherweise kreisförmig. Vorzugsweise liegt ihr Durchmesser im Bereich von 0,1 bis 5 mm, insbesondere 0,5 bis 2 mm. Bei Verwendung schlitzförmiger Düsen werden statt Fäden Bänder erhalten. Eine rasterelektronenmikroskopische Aufnahme (500 x) eines supraleitenden Fadens ist in Fig. 1 dargestellt.

Die verwendeten organischen Lösemittel entziehen der viskosen Lösung das Wasser. Dadurch bilden sich wieder die festen Metall-Polyacrylate.

Als mit Wasser mischbares organisches Lösungsmittel lassen sich insbesondere Methanol, Äthanol oder Aceton einsetzen.

Um eine Versprödung der verdüsten Stränge beim Trocknen zu vermeiden, kann man der viskosen Lösung einen Weichmacher zusetzen. Als Weichmacher dienen zum Beispiel mehrwertige Alkohole, insbesondere Glycerin oder Äthylenglykol. Der zugesetzte Anteil beträgt 0 bis 12, insbesondere 2 bis 10 Gew.-%, bezogen auf die Masse der viskosen Lösung vor dem Eindicken. Es hat sich gezeigt, daß die erzeugten Fäden besser haltbar sind, wenn dem zur Fällung verwendeten organischen Lösungsmittel eine Verbindung zugesetzt wird, die auf Polyacrylsäure vernetzend wirkt, d.h. mindestens zwei mit Carboxylat-Gruppen reagierende Reste enthält, wie z.B. ein Bisepoxid oder Diisocyanat. Verwendbar ist beispielsweise Diethylenglykol-Bisepoxid oder Diphenylmethandiisocyanat (mit Aceton als organischem Lösungsmittel). Diese Mittel vernetzen beim Verdüsen die Oberfläche des entstehenden Strangs und sorgen so für eine bessere Stabilität.

Die beschriebenen viskosen Lösungen sind tiefblau, kolloid-dispers und zeigen den Tyndall-Effekt. Sie eignen sich auch zur Herstellung einer supraleitenden Beschichtung auf einem thermisch beständigen Substrat. Hierzu bringt man eine erfindungsgemäße Lösung in dünner Schicht auf das thermisch beständige Substrat auf, trocknet es und erhitzt Substrat und Beschichtung je nach der Art des zu bildenden Supraleiters auf 800 bis 1000°C in Gegenwart von Sauerstoff, tempert bei mindestens 800°C für mindestens eine Stunde und kühlt dann ab. Als Beschichtungsverfahren eignen sich beispielsweise dip-coating (Tauchbeschichtung) oder spin-coating (Schleuderbeschichtung). Platten aus Al₂O₃, MgO, SrIn₂O₄, ZrO₂, SiTiO₃, CaTiO₃ und LaGaO₃ sind als thermisch beständige Substrate für diesen Zweck einsetzbar.

Das Trocknen der Lösungen dauert mindestens 30 Minuten. Noch besser sind mindestens 60 Minuten, insbesondere mindestens 2 Stunden. Auch hier ist der Zusatz von Weichmachern gut, da sich so die Bildung von Rissen oder Schollen beim Trocknen vermeiden läßt. Thermogravimetrische Untersuchungen haben gezeigt, daß an Luft die Zersetzung von Polyacrylaten relativ stetig zwischen 100°C und 400°C stattfindet. Wenn man nun die Fäden oder Schichten auf 800°C aufheizen will, so ist es vorteilhaft, zunächst im Bereich zwischen 100°C und 400°C die Temperatur langsam zu erhöhen. Zu große Aufheizeraten führen zu einer Verbrennung unter Flammenerscheinung und damit zu ihrer Zerstörung. Als geeignet erwies sich ein Aufheizen von Zimmertemperatur auf 400°C in 10 Stunden und ein Halten bei 400°C während 5 Stunden. Das weitere Aufheizen auf Temperaturen von mindestens 800°C hängt von der Zusammensetzung des Supraleiters ab.

Für einen Supraleiter des Typs YBa₂Cu₃O₇₋ₓ kann das weitere Aufheizen auf 800 bis 1000°C, insbesondere 950°C in 4 Stunden erfolgen. Das Tempern bei 800 bis 900°C, dauert mindestens eine Stunde, vorteilhafterweise mindestens 2 Stunden, insbesondere mindestens 4 Stunden. Es erfolgt ebenfalls in Gegenwart von Sauerstoff. Anschließend wird die Probe langsam, insbesondere während mindestens einer Stunde, vorzugsweise während mindestens 2 Stunden, auf 400°C abgekühlt und bei dieser Temperatur mindestens 10 Stunden gehalten.

Bei Bi-haltigen Supraleitern erfolgt das weitere Aufheizen auf 800-860°C, insbesondere auf 850°C vorzugsweise in mindestens 4 Stunden. Man tempert bei 800-860°C während mindestens einer Stunde in Gegenwart von Sauerstoff, vorteilhafterweise während mindestens 2 Stunden. Langsames Abkühlen bringt in diesem Fall keine Vorteile.

Die Erfindung wird durch die Beispiele näher erläutert.

### Beispiel 1

Lösung 1: 2,2 g Y(NO₃)₃·5H₂O, 3,16 g Ba(NO₃)₂ und 4,4 g Cu(NO₃)₂·3H₂O werden bei 80°C in 60 ml H₂O gelöst.
Lösung 2: 16 g einer 50%igen wäßrigen Polyacrylsäurelösung mit durchschnittlichem Molekulargewicht 5000 werden mit 40 ml Wasser auf 14,3 Gew.-% verdünnt.
Lösung 3: 0,4 g Polyacrylsäure (MW 500.000 bis 1.000.000) werden in ca. 20 ml konzentrierter Ammoniaklösung gelöst.

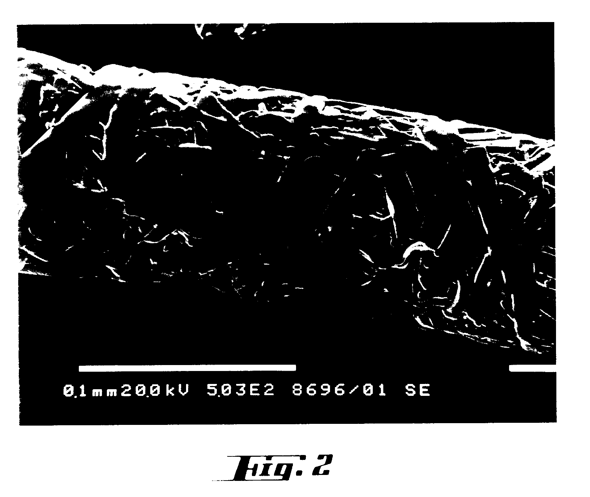

Die drei Lösungen werden vereinigt und die entstehende Trübung wird mit etwa 10 ml konz. Ammoniumhydroxid-Lösung wieder aufgelöst. Der pH-Wert liegt bei 10-11. Anschließend gibt man 20 ml Ethylenglykol hinzu. Die klare, dunkelblaue Lösung wird dann bei 60°C im Verlauf von 48 Stunden bei Normaldruck eingedampft, bis etwa die Viskosität von Honig erreicht ist. Eine Messung ergibt 180 cSt. Der pH-Wert liegt bei 10-11. Die so entstandene Lösung wird durch eine Düse mit einem Durchmesser von 0,5 mm in Methanol gepreßt, wobei lange hellblaue elastische Fäden mit einem Durchmesser von 0,25 mm entstehen. Man zerschneidet in Fasern von ca. 10 cm Länge. Man heizt sie in 10 Stunden von Zimmertemperatur auf 400°C, hält 5 Stunden bei dieser Temperatur, heizt während 4 Stunden auf 950°C und hält 6 Stunden bei dieser Temperatur (in Anwesenheit von Luft) Die Probe wird dann in 4 Stunden auf 400°C abgekühlt und 10 Stunden bei dieser Temperatur gehalten. Man erhält Fasern mit einem Durchmesser von 0,1 mm aus YBa₂Cu₃O₇ mit einer kritischen Temperatur von 89 K. Eine rasterelektronenmikroskopische Aufnahme einer Faser zeigt Figur 2.

Wenn man im Ansatz Lösung 3 (Polyacrylsäure mit hohem Molekulargewicht) wegläßt, so bildet sich zunächst eine klare Lösung, aus der beim Neutralisieren mit Ammoniak ein dicker voluminöser Niederschlag der Polyacrylate ausfällt. Diese gehen bei pH-Werten über 10 wieder in Lösung und es bildet sich eine dunkelblaue, hochviskose Lösung. Es lassen sich Fäden erzeugen, die jedoch ungleichmäßige Dicke aufweisen und spröde sind. Wenn man andererseits ausschließlich Polyacrylsäure mit einem Molekulargewicht von 500 000 bis 10⁶ verwendet, so löst sich dieses Ausgangsprodukt sehr schwer und es bilden sich beim Ausfällen nicht-quellende Niederschläge, die nicht formstabil sind.

### Beispiel 2

Man wiederholt Beispiel 1 aber fügt dem Lösungsmittel, in das verdüst wird, 10 Gew.-% Diethylenglykoldiepoxid zu. Die erhaltenen Precurser-Fasern sind dann elastischer und einfacher zu handhaben.

### Beispiel 3

Beschichtung einer Platte
Zunächst wird gemäß Beispiel 1 eine Lösung mit einer Viskosität von 4500 cSt hergestellt. In diese Lösung wird eine Trägerplatte aus Al₂O₃ (10x50x0,3 mm) eingetaucht und mittels einer Apparatur zur Erzeugung von Langmuir-Blodgett-Filmen mit 1 mm/min aus der Lösung gezogen. Dabei bildet sich eine gleichmäßige türkisfarbene Acrylatschicht auf dem Substrat. Die Reaktion zum supraleitenden Oxid erfolgt nach folgendem Programm: In 10 h auf 400°C heizen und diese Temperatur 5 h halten, in weiteren 4 h auf 950°C heizen und 6 h halten, danach in 4 h auf 400°C abkühlen und die Probe bei dieser Temperatur ca. 4 h auslagern.
Es bildet sich eine schwarze supraleitende Schicht mit der Zusammensetzung YBa₂Cu₃O₇₋ₓ.

### Beispiel 4

Ein getrocknetes Polyacrylat mit einem Metallverhältnis Y:Ba:Cu von 1:2:3 wurde thermisch zersetzt. Das Ergebnis der thermogravimetrischen Analyse geht aus Figur 1 hervor.

## Patentansprüche

1. Lösung enthaltend die Kationen der Metalle Y, Ba, Cu im Atomverhältnis 1:2:3 gebunden an Polyacrylsäure in Wasser als Dispergiermittel mit einer Viscosität von 150-10000 cSt (bei 20°C).

2. Lösung enthaltend die Kationen der Metalle Bi, Sr, Ca und Cu mit den Atomverhältnissen eines Hochtemperatur-Supraleiters, gebunden an Polyacrylsäure in Wasser als Dispergiermittel mit einer Viscosität von 150-10000 cSt (bei 20°C).

3. Verfahren zur Herstellung einer Lösung gemäß Anspruch 1, dadurch gekennzeichnet, daß man Salze der Metalle Y, Ba, Cu im Atomverhältnis 1:2:3 in Wasser oder in Säure löst, die Lösung mit einer wäßrigen Lösung von Polyacrylsäure versetzt, so daß pro Carboxylgruppe der Polyacrylsäure 0,03 bis 0,16 Atome Y³⁺ vorhanden sind, und man durch Zugabe einer thermisch abbaubaren Base einen pH-Wert von mindestens 10 einstellt.

4. Verfahren zur Herstellung einer Lösung gemäß Anspruch 2, dadurch gekennzeichnet, daß man in Wasser oder in Säure Salze der Metalle Bi, Ca, Sr und Cu in einem Atomverhältnis löst, das einem Hochtemperatur-Supraleiter entspricht, man die Lösung mit einer wäßrigen Lösung von Polyacrylsäure vereinigt, wobei pro Carboxylgruppe der Polyacrylsäure 0,04-0,4 Atome Cu²⁺ vorhanden sind und man durch Zugabe einer thermisch abbaubaren Base einen pH-Wert von mindestens 10 einstellt.

5. Verfahren nach Anspruch 3 oder 4, dadurch gekennzeichnet, daß man den Ansatz eindickt, bis er eine Viskosität von 150 bis 10000 cSt aufweist.

6. Verfahren nach Anspruch 3 oder 4, dadurch gekennzeichnet, daß die Nitrate von Y, Ba, Sr, Bi und Cu in Wasser oder Säure gelöst werden.

7. Verfahren nach Anspruch 3 oder 4, dadurch gekennzeichnet, daß man dem Ansatz 2 bis 10 Gew.-% eines Weichmachers zusetzt.

8. Verfahren zur Herstellung eines supraleitenden Fadens, dadurch gekennzeichnet, daß man eine Lösung gemäß Anspruch 1 durch eine Düse preßt und den ausgepreßten fadenförmigen Strang in einem mit Wasser mischbaren organischen Lösungsmittel erstarren läßt, man den Faden isoliert, trocknet, auf 800 bis 1000 °C in Gegenwart von Sauerstoff erhitzt und bei 800 bis 900 °C für mindestens eine Stunde in Gegenwart von Sauerstoff tempert und dann abkühlt.

9. Verfahren zur Herstellung eines supraleitenden Fadens, dadurch gekennzeichnet, daß man eine Lösung gemäß Anspruch 2 durch eine Düse preßt und den ausgepreßten fadenförmigen Strang in einem mit Wasser mischbaren organischen Lösungsmittel erstarren läßt, man den Faden isoliert, trocknet, auf 800 bis 860°C in Gegenwart von Sauerstoff aufheizt und bei 800 bis 860°C für mindestens eine Stunde in Gegenwart von Sauerstoff tempert und dann abkühlt.

10. Verfahren nach Anspruch 8 oder 9, dadurch gekennzeichnet, daß Methanol, Ethanol oder Aceton als mit Wasser mischbares organisches Lösungsmittel eingesetzt werden.

11. Verfahren zur Herstellung einer supraleitenden Beschichtung auf einem thermisch beständigem Substrat, dadurch gekennzeichnet, daß man eine Lösung gemäß Anspruch 1 in dünner Schicht auf das thermisch beständige Substrat aufbringt, trocknet und Substrat + Beschichtung auf 800-1000 °C in Gegenwart von Sauerstoff erhitzt, bei 800-900 °C für mindestens eine Stunde in Gegenwart von Sauerstoff tempert und dann abkühlt.

12. Verfahren zur Herstellung einer supraleitenden Beschichtung auf einem thermisch beständigem Substrat, dadurch gekennzeichnet, daß man eine Lösung gemäß Anspruch 2 in dünner Schicht auf das thermisch beständige Substrat aufbringt, trocknet und Substrat + Beschichtung auf 800-860°C in Gegenwart von Sauerstoff aufheizt, bei 800-860°C in Gegenwart von Sauerstoff für mindestens eine Stunde tempert und dann abkühlt.

13. Verfahren nach Anspruch 11 oder 12, dadurch gekennzeichnet, daß man die Lösung auf dem Substrat durch Tauchbeschichtung oder Schleuderbeschichtung aufbringt.

14. Verfahren nach Anspruch 8 oder 9, dadurch gekennzeichnet, daß man dem Fällungsmedium eine Verbindung zusetzt, die mindestens 2 mit Carboxylat-Gruppen reagierende Reste enthält.

15. Verfahren nach Anspruch 14, dadurch gekennzeichnet, daß man dem Fällungsmedium ein Bis-epoxyd oder Diisocyanat zusetzt.

16. Verfahren nach Anspruch 3 oder 4, dadurch gekennzeichnet, daß man eine Polyacrylsäure mit einem mittleren Molekulargewicht im Bereich von 1000 bis 10000, insbesondere 2000-5000 einsetzt.

17. Verfahren nach Anspruch 16, dadurch gekennzeichnet, daß man dem Ansatz pro Gramm Polyacrylsäure mit Molekulargewicht von 1000 bis 10000, noch 0-0,5 g einer Polyacrylsäure mit einem Molgewicht von 5 x 10⁵ bis 1 x 10⁶ zusetzt.

## Claims

1. A solution containing the cations of the metals Y, Ba, Cu in the atomic ratio 1:2:3 bound to polyacrylic acid in water as dispersant and having a viscosity of 150-10,000 cSt (at 20°C).

2. A solution containing the cations of the metals Bi, Sr, Ca and Cu with the atomic ratios of a high-temperature superconductor bound to polyacrylic acid in water as dispersant and having a viscosity of 150-10,000 cSt (at 20°C).

3. A process for producing a solution as claimed in claim 1, which comprises dissolving salts of the metals Y, Ba, Cu in water or in acid in an atomic ratio of 1:2:3, adding an aqueous solution of polyacrylic acid to the solution so that 0.03 to 0.16 atoms of Y³⁺ are present per carboxyl group of the polyacrylic acid, and adjusting the pH to a value of at least 10 by adding a thermally degradable base.

4. A process for producing a solution as claimed in claim 2, which comprises dissolving salts of the metals Bi, Ca, Sr and Cu in water or in acid in an atomic ratio which corresponds to a high-temperature superconductor, combining the solution with an aqueous solution of polyacrylic acid, 0.04-0.4 atoms of Cu²⁺ being present per carboxyl group of the polyacrylic acid, and the pH being adjusted to a value of at least 10 by adding a thermally degradable base.

5. The process as claimed in claim 3 or 4, wherein the mixture is concentrated until it has a viscosity of 150 to 10,000 cSt.

6. The process as claimed in claim 3 or 4, wherein the nitrates of Y, Ba, Sr, Bi and Cu are dissolved in water or acid.

7. The process as claimed in claim 3 or 4, wherein 2 to 10% by weight of a plasticizer is added to the mixture.

8. A process for producing a superconducting filament, which comprises forcing a solution as claimed in claim 1 through a nozzle and allowing the extruded filamentous strand to solidify in an organic solvent which is miscible with water, isolating the filament, drying, heating to 800 to 1000°C in the presence of oxygen, annealing at 800 to 900°C for at least one hour in the presence of oxygen and then cooling.

9. A process for producing a superconducting filament, which comprises forcing a solution as claimed in claim 2 through a nozzle and allowing the extruded filamentous strand to solidify in an organic solvent which is miscible with water, isolating the filament, drying, heating to 800 to 860°C in the presence of oxygen, annealing at 800 to 860°C for at least one hour in the presence of oxygen and then cooling.

10. The process as claimed in claim 8 or 9, wherein methanol, ethanol or acetone are used as an organic solvent which is miscible with water.

11. A process for producing a superconducting coating on a thermally resistant substrate, which comprises applying a solution as claimed in claim 1 to the thermally resistant substrate in a thin layer, drying and heating the substrate plus coating to 800-1000°C in the presence of oxygen, annealing at 800-900°C for at least one hour in the presence of oxygen and then cooling.

12. A process for producing a superconducting coating on a thermally resistant substrate, which comprises applying a solution as claimed in claim 2 to the thermally resistant substrate in a thin layer, drying and heating the substrate + coating to 800 - 860°C in the presence of oxygen, annealing at 800 - 860°C for at least one hour in the presence of oxygen and then cooling.

13. The process as claimed in claim 11 or 12, wherein the solution is applied to the substrate by dip coating or spin coating.

14. The process as claimed in claim 8 or 9, wherein a compound which contains at least 2 radicals which react with carboxylate groups is added to the precipitation medium.

15. The process as claimed in claim 14, wherein a bisepoxide or diisocyanate is added to the precipitation medium.

16. The process as claimed in claim 3 or 4, wherein a polyacrylic acid having an average molecular weight in the range from 1000 to 10,000, in particular 2000-5000, is used.

17. The process as claimed in claim 16, wherein 0-0.5 g of a polyacrylic acid having a molecular weight of 5 x 10⁵ to 1 x 10⁶ is further added to the mixture per gram of polyacrylic acid having a molecular weight of 1000 to 10,000.

## Revendications

1. Solution contenant les cations des métaux Y, Ba, Cu selon une proportion atomique de 1:2:3 fixés sur de l'acide polyacrylique, dans de l'eau comme milieu de dispersion, cette solution ayant une viscosité de 150 à 10 000 cSt (à 20°C).

2. Solution contenant les cations des métaux Bi, Sr, Ca et Cu, selon des proportions atomiques d'un supraconducteur fonctionnant à température élevée, métaux fixés sur l'acide polyacrylique, dans de l'eau comme milieu de dispersion, la solution ayant une viscosité de 150 à 10 000 cSt (à 20°C).

3. Procédé de préparation d'une solution selon la revendication 1, caractérisé en ce qu'on dissout dans de l'eau ou dans de l'acide des sels des métaux Y, Ba et Cu selon une proportion atomique de 1:2:3, on ajoute à la solution une solution aqueuse d'acide polyacrylique de sorte que, par groupe carboxyle de l'acide polyacrylique, il y ait présence de 0,03 à 0,16 atome de Y³⁺, et, par l'addition d'une base thermiquement décomposable, on ajuste à une valeur de pH valant au moins 10.

4. Procédé de préparation selon la revendication 2, caractérisé en ce qu'on dissout dans de l'eau ou dans de l'acide des sels des métaux Bi, Ca, Sr et Cu selon un rapport atomique correspondant à un supraconducteur fonctionnant à des températures élevées, on combine la solution avec une solution visqueuse d'acide polyacrylique, de manière qu'il y ait par groupe carboxyle de l'acide polyacrylique en présence de 0,04 à 0,4 atome de Cu de plus, et par addition d'une base thermiquement décomposable, on ajuste à une valeur de pH valant au moins 10.

5. Procédé selon la revendication 3 ou 4, caractérisé en ce qu'on épaissit la charge jusqu'à ce qu'elle ait une viscosité de 150 à 10 000 cSt.

6. Procédé selon la revendication 3 ou 4, caractérisé en ce qu'on dissout dans de l'eau ou dans de l'acide les nitrates de Y, Ba, Sr, Bi et Cu.

7. Procédé selon la revendication 3 ou 4, caractérisé en ce qu'on ajoute à la charge 2 à 10 % en poids d'un plastifiant.

8. Procédé de fabrication d'un fil supraconducteur, caractérisé en ce qu'on extrude une solution selon la revendication 1 en la faisant passer par une buse et on laisse refroidir, dans un solvant organique miscible à l'eau, le jonc ou boudin en forme de fil ainsi extrudé, on isole le fil, on le sèche, on le chauffe à 800 jusqu'à 1 000°C en présence d'oxygène et on le conserve pour tempérage à 800 jusqu'à 900°C pendant au moins 1 heure en présence d'oxygène, puis on le refroidit.

9. Procédé de production d'un fil supraconducteur, caractérisé en ce qu'on extrude en la faisant passer par une buse une solution selon la revendication 2, et on laisse refroidir dans un solvant organique miscible à l'eau le jonc ou boudin en forme de fil ainsi extrudé, on isole le fil, on le sèche, on le chauffe à 800 jusqu'à 860°C en présence d'oxygène et on le conserve pour tempérage à 800 jusqu'à 860°C durant 1 heure au moins en présence d'oxygène, puis on le refroidit.

10. Procédé selon la revendicaiton 8 ou 9, caractérisé en ce qu'on utilise du méthanol, de l'éthanol ou de l'acétone comme solvant organique miscible à l'eau.

11. Procédé pour fabriquer un revêtement supraconducteur sur un substrat thermiquement résistant, procédé caractérisé en ce qu'on applique sur le substrat thermiquement résistant une solution selon la revendication 1, en couche mince, on sèche et l'on chauffe en présence d'oxygène le substrat plus le revêtement jusqu'à 800-1 000°C, on maintient en tempérage durant 1 heure au moins à 800-900°C en présence d'oxygène, puis l'on refroidit.

12. Procédé de production d'un revêtement supraconducteur sur un substrat thermiquement résistant, procédé caractérisé en ce qu'on applique sur le substrat thermiquement résistant, en couche mince, une solution selon la revendication 2, on sèche et l'on chauffe en présence d'oxygène le substrat plus le revêtement jusqu'à 800-860°C, on maintient en tempérage durant une heure au moins à 800-860°C en présence d'oxygène, puis on refroidit.

13. Procédé selon la revendication 11 ou 12, caractérisé en ce qu'on applique la solution sur le substrat par revêtement au trempé ou par revêtement centrifuge.

14. Procédé selon la revendication 8 ou 9 caractérisé en ce qu'on ajoute au milieu pour précipitation un composé contenant au moins deux restes pouvant réagir avec les groupes carboxylates.

15. Procédé selon la revendication 14, caractérisé en ce qu'on ajoute au milieu pour précipitation un bis-époxyde ou un diisocyanate.

16. Procédé selon la revendication 3 ou 4, caractérisé en ce qu'on utilise un acide polyacrylique ayant un poids moléculaire moyen se situant entre 1 000 et 10 000, notamment entre 2 000 et 5 000.

17. Procédé selon la revendication 16, caractérisé en ce qu'on ajoute à la charge, par gramme d'acide polyacrylique ayant un poids moléculaire de 1000 à 10 000 encore 0 à 0,5 g d'un acide polyacrylique ayant un poids moléculaire de 5 x 10⁵ à 1 x 10⁶.
